Europäisches Patentamt

European Patent Office

Office européen des brevets

(19)

(11) **EP 1 162 670 A2**

(12) **EUROPEAN PATENT APPLICATION**

(43) Date of publication:
**12.12.2001 Bulletin 2001/50**

(51) Int Cl.⁷: **H01L 33/00**

(21) Application number: **01305058.8**

(22) Date of filing: **11.06.2001**

| | |
|---|---|
| (84) Designated Contracting States:<br>**AT BE CH CY DE DK ES FI FR GB GR IE IT LI LU**<br>**MC NL PT SE TR**<br>Designated Extension States:<br>**AL LT LV MK RO SI** | (72) Inventors:<br>• **Cho, Meoung Whan**<br>  **Kunpo-shi, Kyonggi-do (KR)**<br>• **Takafumi, Yao**<br>  **Aoba-ku, Sendai 98-8577 (JP)** |
| (30) Priority: **09.06.2000 KR 2000031643** | (74) Representative:<br>**McLeish, Nicholas Alistair Maxwell et al**<br>**Boult Wade Tennant**<br>**Verulam Gardens**<br>**70 Gray's Inn Road**<br>**London WC1X 8BT (GB)** |
| (71) Applicants:<br>• **LG ELECTRONICS INC.**<br>  **Seoul (KR)**<br>• **Takafumi, Yao**<br>  **Sendai 980-8577 (JP)** | |

(54) **White light emitting diode and method for fabricating the same**

(57)    White LED and method for fabricating the same, the white LED including a first light emission part of III-V family compound semiconductor on the substrate having an active layer, a second light emission part of II-VI family compound semiconductor on the first light emission part having an active layer, and electrodes in regions of the substrate, and the first and second light emission parts, thereby providing the white LED having a long lifetime, and implementing a wavelength band of a white or a variety of visible lights by growing the III-V family compound semiconductor with a 635 ~ 780nm wavelength range and the II-VI family compound semiconductor with a 450 ~ 550nm wavelength range, with lattices of the two semiconductor matched.

# FIG.5D

## Description

BACKGROUND OF THE INVENTION

Field of the Invention

The present invention relates to white LED (Light Emitting Diode).

Background of the Related Art

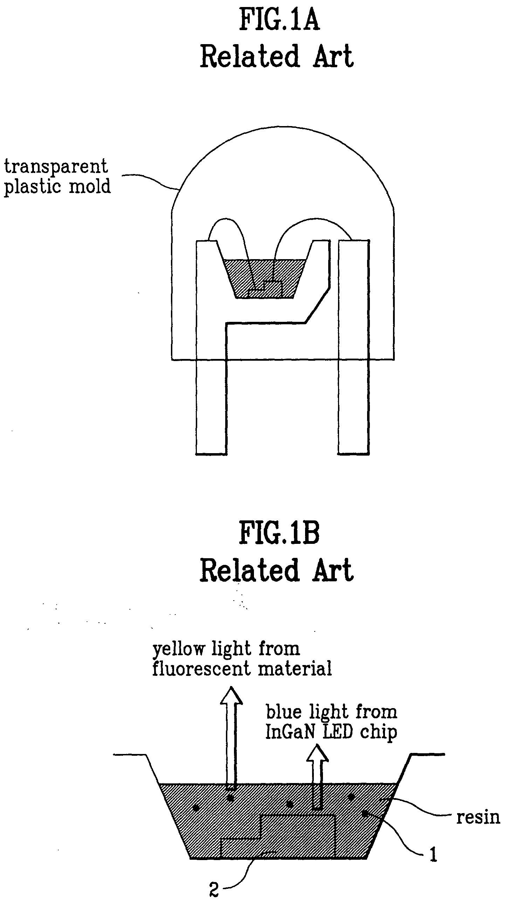

Presently, in continuation from its development, GaN blue LEDs and laser diodes (LD) are reached to a step of putting into market. Recently, white LEDs attracts interests as the white LEDs have substantial market in illumination fields of domestic fluorescent lamps and LCD (Liquid Crystal Display) back lights. In the white LED, there are YAG-GaN white LEDs, ZnSe heteroepitaxy basis white LEDs, and three color (red, green, and blue) LED basis white LEDs. The YAG-GaN white LED is a combination of an InGaN blue LED and YAG (Yitterium Aluminum Garnet) phosphorescent substance. FIG. 1A illustrates a section of a related art In-GaN-YAG white LED, and FIG. 1B illustrates a section showing a detail of the light emitting part in FIG. 1A.

Referring to FIGS. 1A and 1B, the related art InGaN-YAG white LEDs, in a form of bomb, has a resin layer with a YAG fluorescent material scattered therein inserted in a cap part in a lead frame of an LED. A color tone of white light obtainable by changing a ratio of blue/yellow color lights can be achieved by adjusting concentration of YAG fluorescent material mixed with resin.

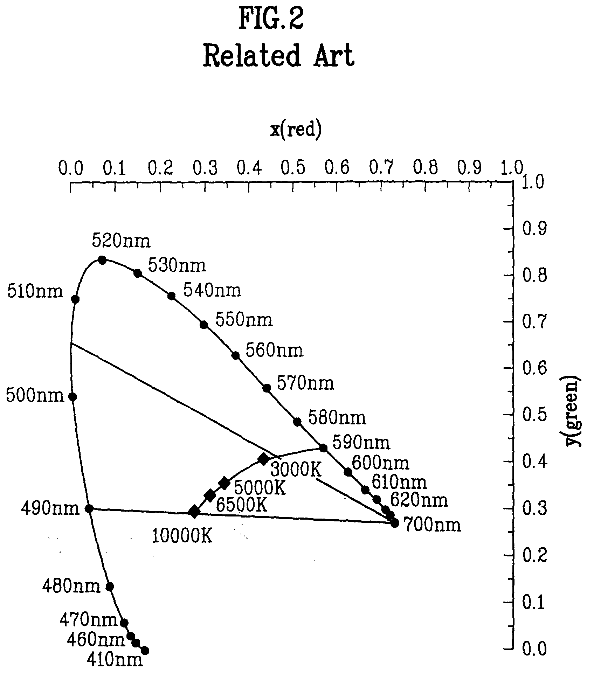

That is, FIG. 2 illustrates a graph showing a chromaticity coordinate system, wherein a straight line connecting a chromaticity point of the YAG fluorescent material 1 and a chromaticity point of the InGaN blue LED 2 represents a variable range of a color tone.

As shown in FIG. 1B, the InGaN-YAG white LED has an InGaN blue LED 2 for emitting a blue color light, and a YAG fluorescent material 1 for emitting a yellowish green color, a combination of the blue color light and the yellowish green color form a white color light.

Thus, since the InGaN-YAG white LED has only one chip, the InGaN-YAG white LED chip requires no control of currents to respective LEDs as in the case a red, green, and blue RGB three color LED. Moreover, the YAG fluorescent material 1 is excited at approx. 460nm, a peak wavelength of the InGaN blue LED 2, has a high transformation efficiency, good water and light resistances, and a low toxicity which is good for environmental protection.

The YAG fluorescent material 1 is prepared by substituting parts of Y sites and Al sites of $Y_3Al_5O_{12}$ with Gd and Ga, which is a stable oxide of a garnet structure.

However, since the transparent YAG fluorescent material 1 absorbs a light from the LED, it has a problem of making a quantum efficiency poor, and reduces yellow components since the YAG fluorescent material 1 has a poor transformation efficiency of approx. 10%. However, an increase of a YAG thickness for increasing the yellow component reduces luminance and quantum efficiencies, further.

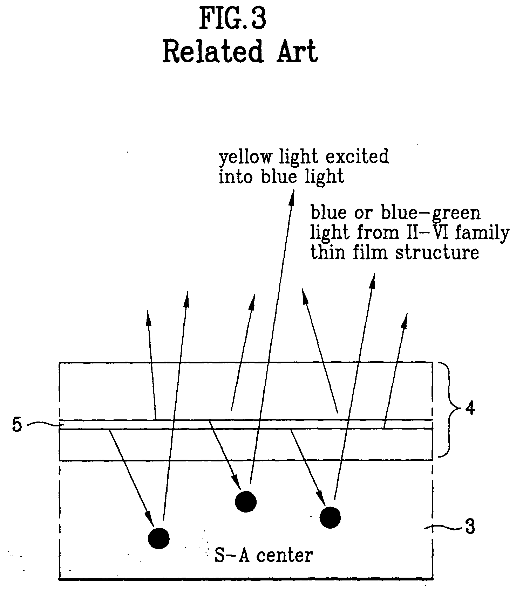

Referring to FIG. 3, the ZnSe heteroepitaxy basis white LED is provided with a single crystal n-type ZnSe substrate 3 having I, Cl, Br, Al, Ga, or In added thereto as an S-A (Self-Absorption) center, and a II-VI family LED 4 having a thin film structured p-n junction for emitting white or intermediate color, inclusive of an active layer 5 of ZnSe, ZnCdSe, ZnSeTe, or the like.

The active layer 5 emits a blue or bluish green light, and an S-A emission center in the ZnSe substrate 3 transforms the blue or bluish green light from the active layer 5 into a yellow or orange light. The blue or bluish green light from the active layer 5 and the yellow or orange light from the ZnSe substrate 3 compose an intermediate or white light between a red light and a blue light. That is, the ZnSe white LED generates, not only white light, but also intermediate color lights present between a red light and a blue light, i.e., a redpurple and pink.

However, the ZnSe white LED has drawbacks of a high production cost coming from use of an expensive ZnSe substrate, difficulty in adjustment of yellow color intensity from the substrate only by doping of the ZnSe substrate, and difficulty in tuning white color by using the same quantity of injection of current.

The three color (red, green, and blue) LED basis white LED has AlGaAs, GaAsP for emitting a red light, GaP for emitting a greenish yellow light, SiC and InGaN for emitting a blue light, and AlGaInP for emitting an orange-yellow light, and the like.

However, the three color (red, green, and blue) LED basis white LED has problems in that the three color hybrid LED is expensive, a complicated circuit for supplying power to respective chips and a complicated driving circuit are required for producing a white color good for illumination or background light, and an assembled final product has a large size.

SUMMARY OF THE INVENTION

Accordingly, the present invention is directed to a white LED and a method for fabricating the same that addresses one or more of the problems due to limitations and disadvantages of the related art.

It would be desirable to provide a white LED and a method for fabricating the same, in which an LED of two wavelengths is provided on one substrate for composing a white or a variety of mixed color lights.

It would also be desirable to provide a white LED and a method for fabricating the same which can reduce production cost by using a simple fabrication process.

Additional features and advantages of the invention will be set forth in the description which follows, and in part will be apparent from the description, or may be learned by practice of the invention. The objectives and other advantages of the invention will be realized and attained by the structure particularly pointed out in the written description and claims hereof as well as the appended drawings.

According to a first aspect of the present invention, there is provided a white LED including a substrate, a first light emission part of III-V family compound semiconductor on the substrate for emission of a light, a second light emission part of II-VI family compound semiconductor on the first light emission part for emission of a light, and electrodes in regions of the substrate, and the first and second light emission parts.

Preferably, the first and second light emission parts have a GaAs contact layers respectively, and the substrate is formed of a material selected from a GaAs group or a ZnSe group.

Preferably, the first light emission part includes multi-quantum well structure of GaAs/AlGaAs group, or InGaP/AlInGaP group, and the second light emission part includes multi-quantum well structure of ZnCdSe/ZnMgSSe group or ZnCdSe/ZnMgBeSe.

In another aspect of the present invention, there is provided a white LED including a GaAs substrate, a first light emission part of multi-quantum well structure of GaAs/AlGaAs or InGaP/AlInGaP on the GaAs substrate having a stack of a first clad layer, a first active layer, and a second clad layer disposed in succession, a GaAs first contact layer on the first light emission part, a second light emission part of multi-quantum well structure of ZnCdSe/ZnMgSSe or ZnCdSe/ZnMgBeSe on the GaAs contact layer having a stack of a third clad layer, a second active layer, and a fourth clad layer disposed in succession, a GaAs second contact layer on the second light emission part, and electrodes under the substrate, and regions of the first and second contact parts.

Preferably, the substrate and the first contact layer are of different conduction types, and the substrate and the second contact layer are of the same conduction type.

In further aspect of the present invention, there is provided a white LED including a GaAs substrate, a first light emission part of multi-quantum well structure of GaAs/AlGaAs or InGaP/AlInGaP on the GaAs substrate having a stack of a first clad layer, a first active layer, and a second clad layer disposed in succession, a GaAs first contact layer on the first light emission part, a second light emission part of multi-quantum well structure of ZnCdSe/ZnMgSSe or ZnCdSe/ZnMgBeSe on the GaAs contact layer having a stack of a third clad layer, a second active layer, and a fourth clad layer disposed in succession, a GaAs second contact layer on the second light emission part, a first electrode under the substrate, a plurality of second electrodes on the first contact layer, a plurality of third electrodes on the second contact layer, and grooves between the second electrodes and between the third electrodes each having a depth for isolating one another.

In still further aspect of the present invention, there is provided a method for fabricating a white LED, including the steps of (a) forming a first light emission part of multi-quantum well structure of GaAs/AlGaAs or InGaP/AlInGaP on a GaAs substrate, and a GaAs first contact layer on the first light emission part, (b) forming a second light emission part of multi-quantum well structure of ZnCdSe/ZnMgSSe or ZnCdSe/ZnMgBeSe on the GaAs contact layer, and a GaAs second contact layer on the second light emission part, (c) etching a portion of the GaAs contact layer and the multi-quantum well structure of ZnCdSe/ZnMgSSe or ZnCdSe/ZnMgBeSe under the GaAs contact layer, for exposing the GaAs first contact layer, and (d) forming electrodes under the substrate and regions of the first and second contact layers.

Preferably, the method for fabricating a white LED further includes the step of etching the exposed GaAs first, and second contact layers and a region under the first, and second layers to a depth, to form grooves, after the step (c).

Preferably, the first light emission part is formed by MOCVD (Metal Organic Chemical Vapor Deposition), or MBE (Molecular Beam Epitaxy), and the second light emission part is formed by MOCVD (Metal Organic Chemical Vapor Deposition), or MBE (Molecular Beam Epitaxy).

It is to be understood that both the foregoing general description and the following detailed description are exemplary and explanatory and are intended to provide further explanation of the invention as claimed.

BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention:

In the drawings:

FIG. 1A illustrates a section of a related art InGaN-YAG white LED;
FIG. 1B illustrates a section showing a detail of the light emitting part in FIG. 1A;
FIG. 2 illustrates a graph showing a chromaticity coordinate system;
FIG. 3 illustrates a section of a related art ZnSe substrate basis white LED;
FIG. 4 illustrates a diagram showing relations of a lattice constant and a band gap of III-V family and II-VI family compound semiconductor;
FIGS. 5A ~ 5E illustrate sections showing the steps of a method for fabricating a white LED in accordance with a preferred embodiment of the present invention; and,

FIG. 6 illustrates a diagram showing a low temperature photoluminescence (PL) spectrum of a white LED embodying the present invention.

## DETAILED DESCRIPTION OF THE PREFERRED EMBODIMENT

Reference will now be made in detail to the preferred embodiments of the present invention, examples of which are illustrated in the accompanying drawings. This document suggests growth of thin films of two different material groups (GaAs group III-V family and ZnSe group II-VI family) on one substrate, to form an LED of two wavelengths, for mixing respective lights from emission layers, to provide a white light or a variety of mixed color lights. This document also suggests to combine MOCVD (Metal Organic Chemical Vapor Deposition) or MBE (Molecular Beam Epitaxy), technologies for growing a III-V family compound semiconductor, and the MBE or MOMBE (Metal Organic Molecular Beam Epitaxy), technologies for growing a II-VI family compound semiconductor, on one substrate, to obtain a white or a variety of mixed color LEDs.

In a case of assessment of a color of light, it is easy to understand to apply an XYZ colorimetric system. In the XYZ colorimetric system, X, Y, Z are expressed as follows.

Equation (1).

$$Y = k \int_{380}^{780} S(\lambda)_X(\lambda) d\lambda$$

$$X = k \int_{380}^{780} S(\lambda)_Y(\lambda) d\lambda$$

$$Z = k \int_{380}^{780} S(\lambda)_Z(\lambda) d\lambda$$

Where, $S(\lambda)$ denotes a relative spectrum distribution of a light, $x(\lambda)$, $y(\lambda)$, and $z(\lambda)$ denote isochromatic functions occurred in the XYZ, and k denotes a constant.

Chromaticity coordinates x, y, and z can be obtained by using the following equation (2) from X, Y, and Z obtained by equation (1).

Equation 2.

$$x = X/(X+Y+Z)$$

$$y = Y/(X+Y+Z)$$

$$z = Z/(X+Y+Z)$$

In the chromaticity coordinates obtained by the equation (2), though an area representing a white color is at around x = 0.33, and y = 0.33, there are numerous combinations of color lights for composing the white color light, such as red+green+blue, red+green, blue+yellow, and the like.

Moreover, the equation (2) facilitates selection of means in obtaining the white color light, either by a combination of a plurality of LEDs, or by an LED and other materials. Thus, the white color light can be obtained, not only from a mixture of the three colors of light, but also a combination of two color lights having appropriate wavelengths as shown in FIG. 2.

Up to now, in a case of the ZnSe group II-VI family compound semiconductor, the MBE growth method is mostly used in fabrication of a blue-bluish green LED. However, since there is no substrate that makes an exact lattice match with the ZnSe, the present invention suggests employing a GaAs substrate that has a small lattice mismatch of 0.27% to the ZnSe.

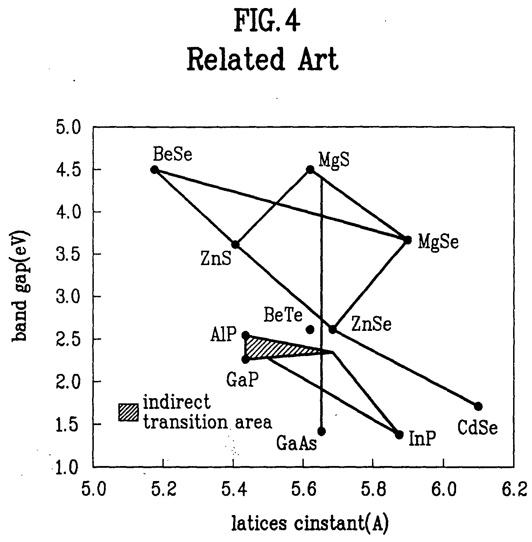

Accordingly, the III-V family and II-VI family compound semiconductor can be grown on the GaAs substrate, with a perfect lattice match made between them, which is understandable from a diagram of a band gap and lattice constant relation of the III-V family and II-VI family compound semiconductor in FIG. 4.

Referring to FIG. 4, the AlGaAs or InGaAlP used as III-V family red LED can make a lattice match with the GaAs substrate, as well as with ZnMgBeSe or ZnMgSSe used as II-VI family bluish green LED, which can prevent occurrence of defects caused by a lattice mismatch between the GaAs substrate and the thin film. The GaAs basis III-V family compound semiconductor may be used as a material for fabricating an LED of 635 ～ 780 nm visible wavelength range, and the II-VI family compound semiconductor may be used as a material for fabricating an LED of 450 ～ 550 nm visible wavelength range.

Accordingly, as shown in the chromaticity coordinates in FIG. 2, the III-V family and II-VI family compound semiconductor facilitates an appropriate wavelength adjustment in the neighborhood of red and blue light region, bluish green and green light region, and to compose a mixed color light, such as white, red purple, or pink, by an appropriate wavelength selection.

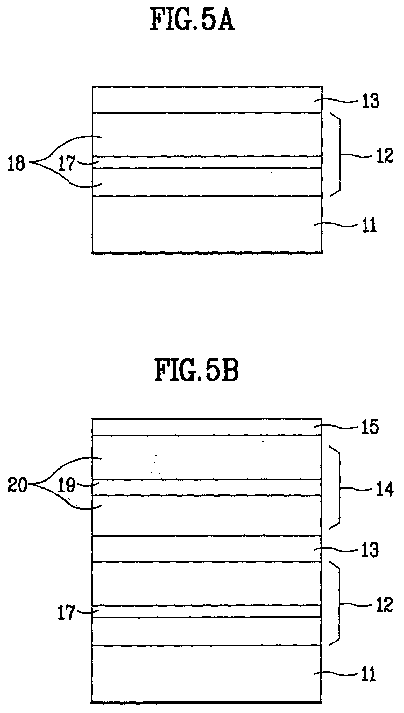

FIGS. 5A ～ 5E illustrate sections showing the steps of a method for fabricating a white LED in accordance with a preferred embodiment of the present invention.

Referring to FIG. 5A, a quantum well structured AlGaAs/GaAs/AlGaAs, InGaAlP/InGaP/InGaAlP, or the like, the III-V family compound semiconductor 12, is grown primarily on p-GaAs substrate 11 by MOCVD or MBE. The AlGaAs or InGaAlP is a cladding layer 18, and GaAs or InGa P is an active layer 17. In this instance, by adjusting composition and a thickness of the quantum well of GaAs or InGaP used as the active layer 17, an LED for emitting a red light of a specific wavelength can be fabricated. Then, a metal contact layer 13 of n-GaAs is formed on the cladding layer 18. The grown metal contact layer 13 of n-GaAs serves as an n-contact for both of the III-V family red LED and the II-VI family blur or bluish green LED in common, and is an initial boundary of the II-VI family compound semiconductor. The AlGaAs/GaAs/AlGaAs, or the InGaAlP/InGaP/InGaAlP, the III-V family compound semiconductor, is grown at an elevated temperature of approx. 650 $\sim$ 750°C.

Then, as shown in FIG. 5B, after a thin film of the GaAs group III-V family compound semiconductor 12 basis LED is grown, a quantum well structured ZnMgSSe/ZnCdSe/ZnMgSSe, or ZnMgBeSe/ZnCdSe/ZnMgBeSe, a II-VI family compound semiconductor 14, is grown on the metal contact layer n-GaAs 13 secondarily by MBE or MOMBE, and a p-contact layer 15 is formed thereon for forming an electrode. The ZnMgSSe or ZnMgBeSe is a cladding layer 20, and the ZnCdSe is an active layer 19. The ZnMgSSe/ZnCdSe/ZnMgSSe, or ZnMgBeSe/ZnCdSe/ZnMgBeSe, a II-VI family compound semiconductor 14, is grown at a low temperature of approx. 250 $\sim$ 350°C.

The III-V family compound semiconductor 12 is primarily grown by MOCVD or MBE, and the II-VI family compound semiconductor 14 is secondarily grown by MBE or MOMBE, for preventing deterioration of device performance caused by collapse of a boundary and inter-diffusion by setting a secondary growth temperature lower than a primary growth temperature. Thus, the primary growth of the GaAs group III-V family compound semiconductor 12 by MOCVD or MBE is done at the high temperature 650 $\sim$ 750°, and the secondary growth of the II-VI family compound semiconductor 14 by MBE or MOMBE is done at a low temperature 250 $\sim$ 350°C.

By the way, a surface treatment for preparation of the secondary growth differs depending on the primary growth method of MOCVD or MBE. That is, if the primary growth is by MOCVD, an oxide film is formed on a surface of the semiconductor layer as the primary grown semiconductor layer is exposed to air. Therefore, in order to remove the oxide film from the surface of the semiconductor layer, the surface of the semiconductor layer is required to be subjected to chemical etching and heat treatment in an MBE chamber. Then, by growing an n-GaAs buffer layer 13 in the MBE chamber, possible defects between the III-V family and II-VI family compound semiconductor 12 and 14 thin films can be suppressed to the maximum. If the primary growth is by MBE, since the substrate is transferred to a II-VI family chamber under a high vacuum for secondary growth after the III-V family compound semiconductor 12 thin film is grown, the growth can be started directly without any special surface treatment.

As shown in FIG. 5C, after the III-V family and II-VI family compound semiconductor 12, and 14 thin films are grown by the primary and secondary growth, the II-VI family compound semiconductor 14 is removed completely for exposing the n-GaAs 13 layer by photolithography and chemical or dry etching.

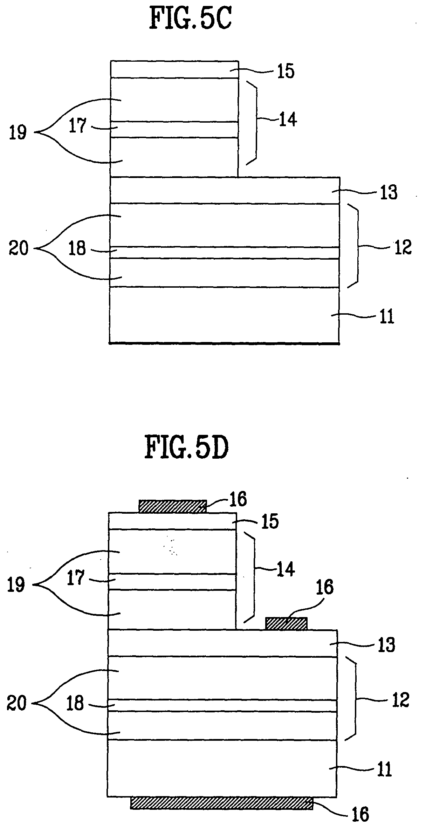

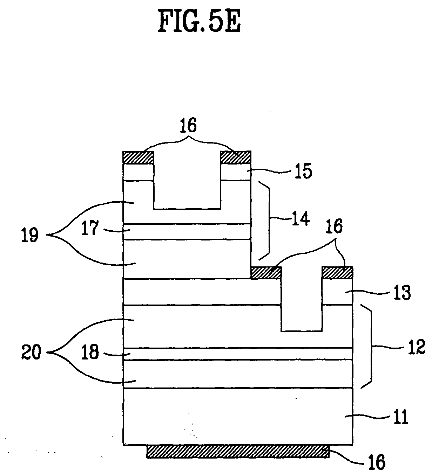

As shown in FIG. 5D, p-metal electrodes 16 are formed on regions of the p-contact layer 15 of the II-VI compound semiconductor 14 and the p-GaAs substrate 11 respectively, and an n-metal electrode 16 is formed on a region of the n-GaAs 13 layer, a contact layer of the III-V family compound semiconductor 12. One in FIG. 5D is an edge emission type LED, and one in FIG. 5E is a surface emission type LED.

As shown in FIG. 5E, the surface emission type LED is etched down to upper parts of the cladding layers 19 and 20 of the III-V family and the II-VI family compound semiconductors 12 and 14 and regions of the active layers 17 and 18 in fabrication of the white LED for enhancing a luminance.

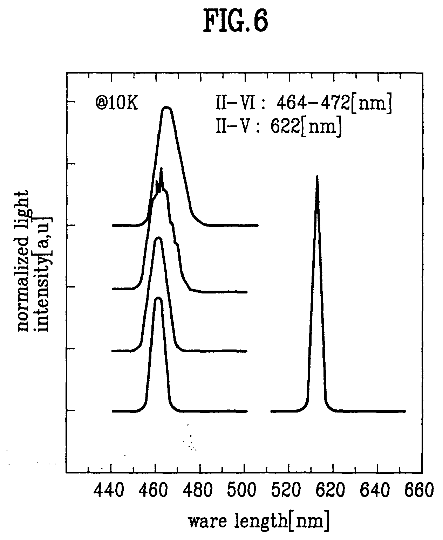

FIG. 6 illustrates a diagram showing a result of a low temperature PL spectrum of the white LED of the present invention, wherein Cd composition in $Zn_xCd_{1-x}Se$ layer used as a quantum well in a II-VI family structure versus wavelength is shown.

By forming a p-n-p-n thryster structure or undoped GaAs layer at an interface of the III-V family and the II-VI family compound semiconductor, a leakage current may be limited.

As has been explained, the white LED and the method for fabricating the same have the following advantages.

First, the growth of III-V family compound semiconductor which has a wavelength of 635 $\sim$ 780nm, and II-VI family compound semiconductor which has a wavelength of 450 $\sim$ 550nm on a GaAs substrate, with lattices of the two kinds of semiconductor matched, permits to fabricate a white LED which allows a long lifetime and to provide white and a variety of visible lights.

Second, in the multi-step growth for fabricating a white LED, the III-V family compound semiconductor 12 is primarily grown by MOCVD or MBE at a high temperature, and the II-VI family compound semiconductor 14 is secondarily grown by MBE or MOMBE at a low temperature, for preventing deterioration of device performance caused by collapse of a boundary and inter-diffusion.

Third, since the white LED can be fabricated by using semiconductor laser process technology, no new process technology is required, and by varying currents to the two LEDs only, a visiable light can be varied.

It will be apparent to those skilled in the art that various modifications and variations can be made in the white LED and the method for fabricating the same herein described without departing from the scope of the invention. Thus, it is intended that the present invention cover the modifications and variations of this invention provided they come within the scope of the appended claims.

## Claims

1. A white LED comprising:

   a substrate;
   a first light emission part of III-V family compound semiconductor on the substrate for emission of a light;
   a second light emission part of II-VI family compound semiconductor on the first light emission part for emission of a light; and,
   electrodes in regions of the substrate, and the first and second light emission parts.

2. A white LED as claimed in claim 1, further comprising a metal contact layer on each of the first and second light emission parts.

3. A white LED as claimed in claim 2, wherein the metal contact layer is of a GaAs group.

4. A white LED as claimed in claim 1, wherein the first light emission part includes multi-quantum well structure of GaAs/AlGaAs group, or InGaP/AlInGaP group.

5. A white LED as claimed in claim 1, wherein the second light emission part includes multi-quantum well structure of ZnCdSe/ZnMgSSe group or ZnCdSe/ZnMgBeSe.

6. A white LED as claimed in claim 1, wherein the electrodes includes;

   a first electrode under the substrate,
   a second electrode on the first light emission part, and
   a third electrode on the second light emission part.

7. A white LED as claimed in claim 1, wherein the electrodes includes;

   a first electrode under the substrate,
   a plurality of second electrodes formed on the first light emission part at fixed intervals, and
   a plurality of third electrodes formed on the second light emission part at fixed intervals, wherein a fixed width groove is formed between adjacent second electrodes and the adjacent third electrodes, to isolate the electrodes.

8. A white LED as claimed in claim 7, wherein the groove has a depth not to expose light emission areas of the first and second light emission parts.

9. A white LED as claimed in claim 1, wherein the substrate is formed of a material selected from GaAs group or ZnSe group.

10. A white LED as claimed in claim 1, wherein the first and second light emission parts emit lights of wavelengths different from each other.

11. A white LED comprising:

   a GaAs substrate;
   a first light emission part of multi-quantum well structure of GaAs/AlGaAs or InGaP/AlInGaP on the GaAs substrate having a stack of a first clad layer, a first active layer, and a second clad layer disposed in succession;
   a GaAs first contact layer on the first light emission part;
   a second light emission part of multi-quantum well structure of ZnCdSe/ZnMgSSe or ZnCdSe/ZnMgBeSe on the GaAs contact layer having a stack of a third clad layer, a second active layer, and a fourth clad layer disposed in succession;
   a GaAs second contact layer on the second light emission part; and,
   electrodes under the substrate, and regions of the first and second contact parts.

12. A white LED as claimed in claim 11, wherein the substrate and the first contact layer are of different conduction types, and the substrate and the second contact layer are of the same conduction type.

13. A white LED comprising:

   a GaAs substrate;
   a first light emission part of multi-quantum well structure of GaAs/AlGaAs or InGaP/AlInGaP on the GaAs substrate having a stack of a first clad layer, a first active layer, and a second clad layer disposed in succession;
   a GaAs first contact layer on the first light emission part;
   a second light emission part of multi-quantum well structure of ZnCdSe/ZnMgSSe or ZnCdSe/ZnMgBeSe on the GaAs contact layer having a stack of a third clad layer, a second active layer, and a fourth clad layer disposed in succession;
   a GaAs second contact layer on the second light emission part;
   a first electrode under the substrate;
   a plurality of second electrodes on the first contact layer;
   a plurality of third electrodes on the second contact layer; and,
   grooves between the second electrodes and between the third electrodes each having a depth for isolating one another.

**14.** A white LED as claimed in claim 13, wherein the substrate and the first contact layer are of different conduction types, and the substrate and the second contact layer are of the same conduction type.

**15.** A white LED as claimed in claim 13, wherein the groove has a depth not to expose active layers of the first and second light emission parts.

**16.** A method for fabricating a white LED, comprising the steps of:

(a) forming a first light emission part of multi-quantum well structure of GaAs/AlGaAs or In-GaP/AlInGaP on a GaAs substrate, and a GaAs first contact layer on the first light emission part;
(b) forming a second light emission part of multi-quantum well structure of ZnCdSe/ZnMgSSe or ZnCdSe/ZnMgBeSe on the GaAs contact layer, and a GaAs second contact layer on the second light emission part;
(c) etching a portion of the GaAs contact layer and the multi-quantum well structure of ZnCdSe/ZnMgSSe or ZnCdSe/ZnMgBeSe under the GaAs contact layer, for exposing the GaAs first contact layer; and,
(d) forming electrodes under the substrate and regions of the first and second contact layers.

**17.** A method as claimed in claim 16, further comprising the step of etching the exposed GaAs first, and second contact layers and a region under the first, and second layers to a depth, to form grooves, after the step (c).

**18.** A method as claimed in claim 16, wherein the substrate and the first contact layer are of different conduction types, and the substrate and the second contact layer are of the same conduction type.

**19.** A method as claimed in claim 16, wherein the first light emission part is formed by MOCVD (Metal Organic Chemical Vapor Deposition), or MBE (Molecular Beam Epitaxy).

**20.** A method as claimed in claim 16, wherein the second light emission part is formed by MOCVD (Metal Organic Chemical Vapor Deposition), or MBE (Molecular Beam Epitaxy).

# FIG.1A
# Related Art

transparent
plastic mold

# FIG.1B
# Related Art

yellow light from
fluorescent material

blue light from
InGaN LED chip

resin

1

2

# FIG.2
# Related Art

# FIG.3
# Related Art

yellow light excited
into blue light

blue or blue-green
light from II-VI family
thin film structure

5

4

3

S-A center

FIG. 4
Related Art

# FIG.5A

# FIG.5B

## FIG.5C

## FIG.5D

# FIG.5E

# FIG.6

@10K  II−VI : 464−472[nm]
II−V : 622[nm]

normalized light intensity[a,u]

ware length[nm]

440  460  480  500  520  620  640  660